(19) **Europäisches Patentamt / European Patent Office / Office européen des brevets**

(11) **EP 3 506 486 B1**

(12) **FASCICULE DE BREVET EUROPEEN**

(45) Date de publication et mention de la délivrance du brevet:
**06.01.2021  Bulletin 2021/01**

(51) Int Cl.:
**H02M 7/483** (2007.01)   **H03K 7/08** (2006.01)

(21) Numéro de dépôt: **18215876.6**

(22) Date de dépôt: **24.12.2018**

(54) **PROCÉDÉ DE MODULATION DE LARGEUR D'IMPULSIONS**

IMPULSBREITEN-MODULATIONSVERFAHREN

METHOD FOR PULSE WIDTH MODULATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.12.2017  FR 1763276**

(43) Date de publication de la demande:
**03.07.2019  Bulletin 2019/27**

(73) Titulaire: **Commissariat à l'Énergie Atomique et aux Énergies Alternatives**
**75015 Paris cedex (FR)**

(72) Inventeurs:
- **CASSARINO, Leandro**
  **33400 Talence (FR)**
- **DESPESSE, Ghislain**
  **38340 Voreppe (FR)**

(74) Mandataire: **INNOV-GROUP**
**310, avenue Berthelot**
**69372 Lyon Cedex 08 (FR)**

(56) Documents cités:
**EP-A2- 0 745 951      GB-A- 2 080 060**
**US-A1- 2017 074 168**

**Description**

## DOMAINE TECHNIQUE

Le domaine technique de l'invention est la modulation de largeur d'impulsion pour générer un signal de commande électrique, par exemple à l'attention d'un circuit de puissance, en particulier un moteur.

## ART ANTERIEUR

La technique de modulation de largeur d'impulsions, fréquemment désignée par l'acronyme anglo-saxon PWM, signifiant "Pulse Width Modulation", consiste à générer des impulsions de type créneau selon un rapport cyclique pour former un signal de commande, permettant par exemple de commander un circuit de puissance. Le circuit de puissance peut être un moteur, synchrone ou asynchrone. Il comporte généralement un filtre passe-bas inductif, de telle sorte que la modulation du rapport cyclique permet, après filtrage, la formation d'un signal continu, dont l'amplitude dépend du rapport cyclique. On obtient ainsi un signal variable en fréquence et en amplitude.

Le document EP0745951 décrit une formation d'un signal modulé en amplitude résultant d'une lecture d'un code barre par un scanner optique.

La modulation de largeur d'impulsion est couramment utilisée pour piloter des onduleurs de tension destinés à la commande de moteurs triphasés. La plupart des générateurs d'impulsions de type PWM génèrent des impulsions à fréquence fixe, le rapport cyclique des impulsions étant déterminé en fonction de la valeur d'un signal de référence, de façon à obtenir le signal de commande souhaité. Lorsque le signal de référence est un signal périodique, la fréquence des impulsions est nettement supérieure à la fréquence du signal de référence, de façon à obtenir un signal de commande, représentatif du signal de référence, formé par une moyenne de la valeur des impulsions sur quelques périodes.

Le document EP0336019 décrit un procédé multiniveaux de modulation par largeur d'impulsion, selon lequel l'impulsion formée peut prendre trois niveaux de tension discrets en fonction du signal de référence. On aboutit à la formation d'un signal de commande impulsionnel commutant entre les différents niveaux, selon une fréquence, dite fréquence de hachage, fixe et déterminée arbitrairement, le rapport cyclique entre les différents niveaux étant modulé. La fréquence de hachage correspond par exemple à la fréquence entre deux fronts montants ou deux fronts descendants du signal de commande formé. Cela pose une difficulté, car la fréquence de hachage est généralement dimensionnée selon des hypothèses conservatrices, ce qui induit un nombre élevé de commutations.

Un autre inconvénient est que les instants de commutations ne sont pas maîtrisés et ne sont déterminés que par une comparaison entre le signal de référence et une onde, dite onde porteuse, triangulaire. Ces instants de commutation ne sont pas optimisés.

Une autre difficulté est que la durée d'une impulsion, c'est-à-dire la durée à laquelle le signal de commande prend une même valeur, est aléatoire. Plus particulièrement, la durée d'une impulsion peut être très courte, ce qui n'est pas optimal. En effet, la transition entre deux niveaux de tension n'est pas immédiate. Lorsque la durée d'une impulsion est trop courte, la durée de transition devient significative par rapport à la durée de l'impulsion, ce qui induit des pertes significatives d'énergie transmise. En effet, chaque commutation conduit à une perte d'énergie. Plus les commutations sont nombreuses et rapprochées les unes des autres, plus la puissance dissipée est importante, tout en ayant peu d'effet sur la qualité du signal de commande filtré.

Les inventeurs ont proposé un procédé de modulation surmontant ces difficultés. Ils proposent un procédé permettant d'améliorer la qualité de la modulation, de façon à former un signal de commande qui, après application d'un filtre passe bas, soit davantage représentatif du signal de référence, tout en optimisant le nombre de commutations, limitant ainsi les pertes d'énergie. Par ailleurs, un autre avantage du procédé est une mise en œuvre peu couteuse en mémoire, en particulier pour les signaux périodiques.

## EXPOSE DE L'INVENTION

Un premier objet de l'invention est un procédé de génération d'un signal de commande par modulation d'impulsions en fonction d'un signal de référence, le procédé comportant une formation de séquences de modulation successives, chaque séquence comportant une transition entre un état bas et un état haut ou réciproquement, le procédé comportant les étapes itératives suivantes, chaque itération étant associée à un instant, dit instant courant :

a) calcul d'une dérivée temporelle du signal de référence, la dérivée étant associée à une séquence de modulation, dite séquence courante, correspondant à l'instant courant ;
b) en fonction de la dérivée temporelle du signal de référence calculée lors de l'étape a), définition de la séquence courante, de telle sorte que :

■ lorsque la dérivée est positive, la séquence courante comporte un état haut précédé d'un état bas, l'état haut s'étendant jusqu'à la fin de la séquence courante ;

■ lorsque la dérivée est négative, la séquence courante comporte un état haut suivi d'un état bas, l'état bas s'étendant jusqu'à la fin de la séquence courante ;

l'état bas et l'état haut s'étendant respectivement selon une durée d'état bas et une durée d'état haut, la séquence courante, s'étendant, à partir de l'instant courant, selon une durée de séquence ;

c) prise en compte d'un niveau haut, correspondant à l'état haut, et d'un niveau bas, correspondant à l'état bas, le niveau haut étant strictement supérieur au niveau bas ;

d) en fonction de l'amplitude du signal de référence et des niveaux haut et bas pris en compte lors de l'étape c), détermination de la durée de l'état haut ou de la durée de l'état bas de la séquence courante définie lors de l'étape b) ;

e) réitération des étapes a) à e), en incrémentant l'instant courant d'une durée égale à la durée de la séquence résultant de l'étape d), ou arrêt des itérations ;

le procédé comportant également une génération du signal de commande, en fonction des séquences de modulation définies lors des étapes d) des différentes itérations successives.

L'étape d) peut comporter une prise en compte d'une durée minimale, ainsi que les sous-étapes suivantes :

di) en fonction de la séquence définie lors de l'étape b), et de l'amplitude du signal de référence durant la durée de séquence, calcul d'une durée complémentaire, la durée complémentaire correspondant :

■ à la durée de l'état bas lorsque la dérivée du signal de référence est positive, la durée de l'état haut étant alors fixée à la durée minimale ;

■ à la durée de l'état haut lorsque la dérivée du signal de référence est négative, la durée de l'état bas étant alors fixée à la durée minimale ;

dii) comparaison de la durée complémentaire et de la durée minimale ;

diii) lorsque la durée complémentaire est inférieure à la durée minimale, invalidation de la durée complémentaire résultant de la sous-étape di), et détermination d'une durée complémentaire correspondant à :

■ la durée de l'état haut, lorsque la dérivée du signal de référence est positive, la durée de l'état bas étant alors fixée à la durée minimale ;

■ la durée de l'état bas, lorsque a dérivée du signal de référence est négative, la durée de l'état haut étant alors fixée à la durée minimale.

Lors de l'étape d), la durée complémentaire peut être calculée en fonction de l'intégrale du signal de référence durant la durée de la séquence courante et du niveau haut pris en compte lors de l'étape c). La durée complémentaire peut être calculée de telle sorte que l'intégrale du signal de référence, diminué du niveau bas, durant la durée de séquence, est égale, à une tolérance prédéterminée près, au produit du niveau haut, diminué du niveau bas, par la durée de l'état haut.

Le procédé peut comporter les sous-étapes suivantes :

div) détermination de la présence d'un instant, dit d'arrêt, correspondant à un instant caractéristique du signal de référence ou de sa dérivée, durant la séquence courante ;

dv) lorsqu'un instant d'arrêt est détecté, annulation de la séquence courante et ajustement de la séquence précédente, définie lors de l'itération précédente, de façon à ce que la séquence précédente s'étende entre l'instant précédent et l'instant d'arrêt ($t_a$).

La séquence précédente peut être ajustée de façon que :

■ lorsque, à l'instant précédent, la dérivée du signal de référence est positive, l'état haut de la séquence précédente s'étend jusqu'à l'instant d'arrêt ;

■ lorsque, à l'instant précédent, la dérivée du signal de référence est négative, l'état bas de la séquence précédente s'étend jusqu'à l'instant d'arrêt.

L'instant d'arrêt peut correspondre :

■ à un instant auquel le signal de référence change de signe ;

- ou à un instant auquel la dérivée du signal de référence change de signe ;
- ou le signal de référence étant périodique, à un instant correspondant à la fin d'une période du signal de référence ;
- ou à un instant auquel le signal de référence atteint l'état haut ou l'état bas.

Selon un mode de réalisation, lors de l'étape b), la séquence définie comporte un seul état haut et un seul état bas.
Selon un mode de réalisation, lors de l'étape c), la détermination du niveau haut et du niveau bas est effectuée en fonction de valeurs prédéterminées, et en fonction du signal de référence durant la durée de l'impulsion.
Un autre objet de l'invention est un dispositif de génération d'un signal de commande, en fonction d'un signal de référence, le dispositif comportant un processeur apte à mettre les étapes a) à e) d'un procédé selon le premier objet de l'invention, en fonction du signal de référence.
D'autres avantages et caractéristiques ressortiront plus clairement de la description qui va suivre de modes particuliers de réalisation de l'invention, donnés à titre d'exemples non limitatifs, et représentés sur les figures listées ci-dessous.

## FIGURES

La figure 1A représente les principales étapes d'un procédé selon l'invention.
La figure 1B schématise les principaux composants d'un dispositif pour la mise en œuvre de l'invention.
Les figures 2A à 2F montrent différentes séquences de modulation, correspondant respectivement à différentes situations.
Les figures 3A à 3D représentent des exemples de modulation de signaux périodiques en mettant en œuvre l'invention.
Les figures 4A à 4D illustrent des essais comparatifs entre une modulation d'un signal sinusoïdal effectuée selon l'art antérieur et selon l'invention.

## EXPOSE DE MODES DE REALISATION PARTICULIERS

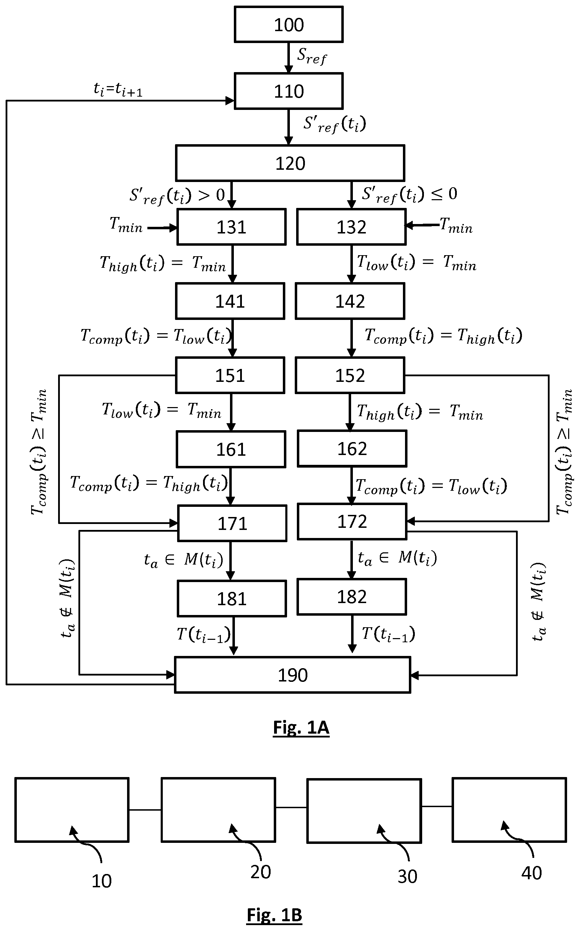

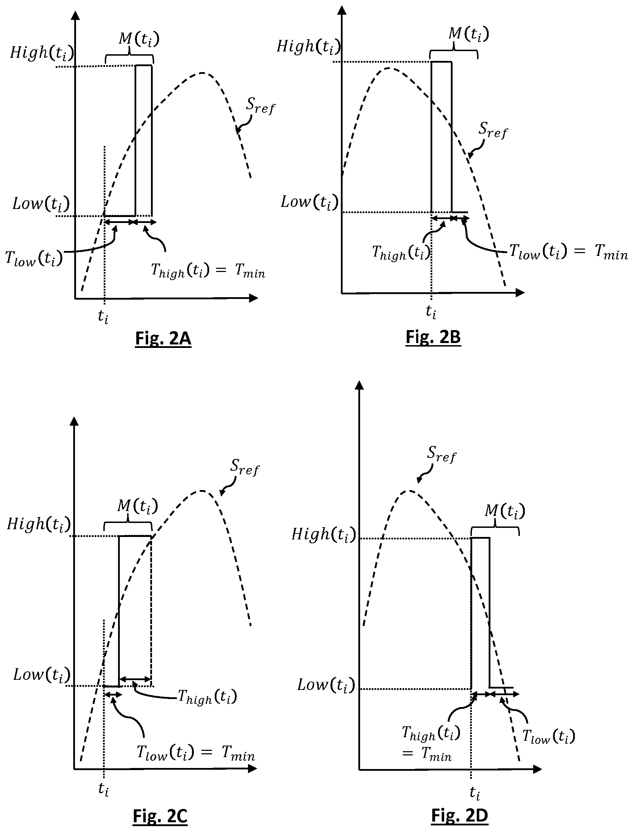

On a représenté, sur la figure 1A, les principales étapes d'un mode de réalisation de l'invention donné à titre d'exemple non limitatif. La figure 1B schématise un dispositif permettant la mise en œuvre du mode de réalisation décrit en lien avec la figure 1A. Les figures 2A à 2F illustrent des séquences de modulation correspondant à des configurations décrites en lien avec les étapes de la figure 1A. Le procédé présenté en lien avec la figure 1A est un procédé itératif, à chaque itération i étant associée à un instant $t_i$, dit instant courant. Le procédé consiste à établir un signal de commande $S_c$, comportant une succession de séquences de modulation $M(t_i)$. Chaque séquence de modulation $M(t_i)$ est paramétrée par un niveau bas $low(t_i)$ et un niveau haut $high(t_i)$, ces niveaux étant associés à l'instant courant $t_i$. Au cours de chaque séquence, le signal de commande comporte :

- un état bas, durant lequel le signal de commande est maintenu au niveau bas $low(t_i)$;
- un état haut, au cours de laquelle le signal de commande est maintenu au niveau haut $high(t_i)$.

La commutation entre un état bas et un état haut forme une transition, Une telle transition est considérée comme suffisamment rapide pour être négligée. Ainsi, au cours de chaque séquence de modulation, le signal de commande oscille essentiellement entre deux valeurs discrètes, correspondant respectivement aux niveaux haut et bas. Le terme essentiellement s'entend aux transitions près entre l'état haut et un l'état bas ou réciproquement.
Selon une variante, il n'y a que deux niveaux, indépendants de l'instant courant, et communs à chaque séquence : un niveau bas, par exemple correspondant à une tension nulle, et un niveau haut, correspondant à la hauteur de chaque état haut. Parfois, la modulation est de type multiniveaux, le nombre et la valeur des niveaux correspondant à des données prédéterminées. Un exemple de modulation à trois niveaux est donné dans EP0336019.
Les principales étapes du mode de réalisation schématisé sur la figure 1A sont à présent décrites. Ces étapes sont mises en œuvre à différents instants courants, chaque instant courant $t_i$ étant incrémenté entre deux itérations successives, entre un instant initial $t_0$ et un instant final $t_f$.
Etape 100 : prise en compte d'un signal de référence $S_{ref}$. Le signal de référence $S_{ref}$ correspond au signal par rapport auquel la modulation est effectuée. Il s'agit d'une donnée d'entrée du procédé.
Etape 110 : calcul d'une dérivée temporelle du signal de référence à l'instant courant $t_i$, ou à un instant suffisamment proche de l'instant courant pour que la dérivée temporelle puisse être associée à la séquence de modulation $M(t_i)$ correspondant à l'instant courant. Le signal de référence étant généralement échantillonné dans le temps, la dérivée $S'_{ref}(t_i)$ correspond à un taux de variation, c'est-à-dire une différence du signal de référence entre deux instants, par

4

exemple l'instant $t_i \mp \delta t$ et l'instant courant $t_i$, ladite différence étant normalisée par une différence $\delta t$ entre ces instants.

<u>Etape 120</u> : détermination du signe de la dérivée du signal de référence $S'_{ref}(t_i)$ à l'instant courant $t_i$. Un aspect important du procédé est que chaque séquence de modulation $M(t_i)$, associée à un instant courant $t_i$, dépend du signe de la dérivée du signal de référence $S'_{ref}(t_i)$ à l'instant courant $t_i$.

Lorsque la dérivée $S'_{ref}(t_i)$ est positive, la séquence de modulation $M(t_i)$ associée à un instant courant $t_i$ est une première séquence de modulation, comprenant :

- un état bas, durant lequel le signal de commande est maintenu au niveau bas $low(t_i)$, durant une durée d'état bas $T_{low}(t_i)$;
- un état haut, durant lequel le signal de commande est maintenu au niveau haut $high(t_i)$, durant une durée d'état haut $T_{high}(t_i)$.

L'état bas s'étend entre le début de la séquence et l'état haut, ce dernier s'étendant jusqu'à la fin de la séquence ; la durée $T(t_i)$ de la séquence est telle que :

$$T(t_i) = T_{low}(t_i) + T_{high}(t_i)\ (1).$$

La figure 2A représente une telle séquence. Le paramétrage de la première séquence est décrit en lien avec les étapes 131, 141, 151, 161, 171 et 181.

Lorsque la dérivée $S'_{ref}(t_i)$ est négative, la séquence de modulation $M(t_i)$ associée à un instant courant $t_i$ est une deuxième séquence de modulation, comprenant :

- un état haut, durant laquelle le signal de commande est maintenu au niveau haut $high(t_i)$, durant une durée d'état haut $T_{high}(t_i)$.
- puis un état bas, durant lequel le signal de commande est maintenu au niveau bas $low(t_i)$, durant une durée d'état bas $T_{low}(t_i)$.

L'état haut s'étend entre le début de la séquence $M(t_i)$ et l'état bas, ce dernier s'étendant jusqu'à la fin de la séquence ; la durée de la séquence $T(t_i)$ est telle que :

$$T(t_i) = T_{high}(t_i) + T_{low}(t_i)\ (1').$$

La figure 2B représente une telle séquence. Le paramétrage de la deuxième séquence est décrit en lien avec les étapes 132, 142, 152, 162, 172 et 182.

Quelle que soit la séquence $M(t_i)$ prise en compte, le niveau haut $high(t_i)$ et le niveau bas $low(t_i)$ sont constants, durant la séquence, et déterminés en fonction de valeurs définies préalablement. Ils sont définis, lors de chaque séquence, en considérant l'évolution du signal de référence $S_{ref}$ durant la durée de la séquence $T(t_i)$. Le dispositif peut comprendre un module de calcul, prenant en compte des niveaux discrets de tension. Les niveaux $high(t_i)$ et $low(t_i)$ peuvent par exemple être déterminés en calculant une valeur moyenne $\overline{S}_{ref}(t_i)$ du signal de référence $S_{ref}(t_i)$ selon la durée $T(t_i)$ de la séquence $M(t_i)$. Les niveaux $high(t_i)$ et $low(t_i)$ correspondant à la séquence sont alors des niveaux discrets, préétablis, encadrant la valeur moyenne $\overline{S}_{ref}(t_i)$. Il peut en particulier s'agir de niveaux discrets respectivement immédiatement supérieur et inférieur à la moyenne calculée. Les niveaux $high(t_i)$ et $low(t_i)$ peuvent également être déterminés en prenant en compte la valeur du signal de référence $S_{ref}(t_i)$ à l'instant courant $t_i$. On se base alors sur une hypothèse selon laquelle la fréquence de modulation est suffisamment élevée, par rapport à l'évolution du signal de référence, pour que les niveaux haut $high(t_i)$ et bas $low(t_i)$ soient des niveaux discrets préétablis respectivement de part et d'autre de la valeur du signal de référence $S_{ref}(t_i)$ à l'instant courant $t_i$. Il peut en particulier s'agir des niveaux discrets respectivement immédiatement supérieur et inférieur à la valeur du signal de référence $S_{ref}(t_i)$.

On décrit à présent les étapes 131, 141, 151, 161, 171 et 181, visant à paramétrer la première séquence, correspondant à une dérivée positive du signal de référence.

<u>Etape 131</u> : Prise en compte d'une durée minimale. Selon cette étape, on prend en compte une durée minimale $T_{min}(t_i)$, associée à l'instant courant $t_i$ ; la durée de l'état haut est fixée à cette durée minimale : $T_{high}(t_i) = T_{min}(t_i)$. Dans cet exemple, la durée minimale $T_{min}(t_i)$ est commune à chaque instant courant $t_i$, de telle sorte que pour chacun de ces instants, $T_{min}(t_i) = T_{min}$. Selon d'autres exemples, la durée minimale $T_{min}(t_i)$ peut être modulée en fonction de la valeur du signal de référence $S_{ref}(t_i)$ ou d'autres paramètres, par exemple une comparaison entre les niveaux haut et bas de la séquence précédente $M(t_{i-1})$ et de la séquence courante $M(t_i)$. Généralement, la durée minimale $T_{min}(t_i)$ est supérieure ou égale à 5 μs ou à 10 μs. La prise en compte d'une durée minimale permet de ne pas constituer un état haut d'une durée trop courte.

Etape 141 : Détermination d'une durée complémentaire $T_{comp}(t_i)$ qui, ajoutée à la durée minimale $T_{min}$, forme la durée $\overline{T(t_i)}$ de la séquence. Dans ce cas, la durée complémentaire $T_{comp}(t_i)$ correspond à la durée de l'état bas $T_{low}(t_i)$. Le niveau $high(t_i)$ de l'état haut étant fixé, la durée de l'état bas est déterminée de telle sorte que l'amplitude de l'état haut, diminuée du niveau bas $low(t_i)$, intégrée selon la durée $T_{min}$, corresponde à l'intégrale du signal de référence $S_{ref}$, également diminué du niveau bas $low(t_i)$, durant la durée $T(t_i)$ de la séquence de modulation $M(t_i)$.

Cela peut se traduire par les équations suivantes :

$$\int_{t_i}^{t_i+T}\big(S_{ref}(k) - low(t_i)\big)dk = (high(t_i) - low(t_i)) \times T_{min} (2)$$

Sachant que $T(t_i) = T_{min} + T_{comp}(t_i) = T_{min} + T_{low}(t_i)$ (3) car $T_{high}(t_i) = T_{min}$

Ces équations forment un système à deux équations, dont les données d'entrée sont $high(t_i)$, $low(t_i)$ et $T_{min}$ et dont les inconnues sont les durées $T(t_i)$ et $T_{low}(t_i)$.

L'équation (2) traduit une autre particularité du mode de réalisation : lors de chaque séquence de modulation $M(t_i)$, l'intégrale du signal de commande durant l'état haut, au-dessus du niveau bas $low(t_i)$, correspond à l'intégrale du signal de référence $S_{ref}$, au-dessus du niveau bas $low(t_i)$. L'intégrale du signal de commande, durant la séquence de modulation, correspond alors à l'intégrale du signal de référence.

Etape 151 : Validation de la séquence de modulation $M(t_i)$. La séquence est validée si $T_{comp}(t_i) \geq T_{min}$, c'est-à-dire si $\overline{T_{low}(t_i)} \geq T_{min}$. On passe alors à l'étape 171. Dans le cas contraire, la séquence de modulation est invalidée et paramétrée selon l'étape 161.

Etape 161 : re-paramétrage de la séquence de modulation. Au cours de cette étape, la séquence est paramétrée de telle sorte que la durée de l'état bas $T_{low}(t_i)$ est fixé à la durée minimale $T_{min}$. Il faut alors déterminer une durée complémentaire $T_{comp}(t_i)$, telle que définie dans l'étape 131, correspondant ici la durée $T_{high}(t_i)$ de l'état haut. Cette dernière est calculée de telle sorte que l'intégrale de l'état haut, en dessus du niveau bas $low(t_i)$, corresponde à l'intégrale du signal de référence $S_{ref}$, au-dessus du niveau bas, durant la séquence. Cf. figure 2C. Cela se traduit par les expressions suivantes :

$$\int_{t_i}^{t_i+T}\big(S_{ref}(k) - low(t_i)\big)dk = (high(t_i) - low(t_i)) \times T_{high}(t_i) (4)$$

et

$$T(t_i) = T_{min} + T_{comp}(t_i) = T_{min} + T_{high}(t_i) (5).$$

Ces équations forment un système à deux équations, dont les données d'entrée sont $high(t_i)$, $low(t_i)$ et $T_{min}$ et dont les inconnues sont les durées $T(t_i)$ et $T_{high}(t_i)$.

Etape 171 : Détection d'un instant d'arrêt. La séquence de modulation étant paramétrée, soit suite à l'étape 141, soit suite à l'étape 161, l'étape 171 comporte la détection, au cours de la durée $T(t_i)$ de la séquence, d'un instant particulier $t_a$, désigné par le terme instant d'arrêt, correspondant à au moins une des conditions suivantes :

- le signal de référence $S_{ref}$ change de signe de part et d'autre de $t_a$;
- la dérivée $S'_{ref}$ du signal de référence change de signe de part et d'autre de $t_a$;
- le signal de référence $S_{ref}$ est périodique et atteint la fin d'une période à l'instant d'arrêt;
- le signal de référence $S_{ref}$ atteint un niveau haut $high(t_i)$ ou un niveau bas $low(t_i)$.

Lorsque la séquence $M(t_i)$ ne comporte pas d'instant d'arrêt ($t_a \notin M(t_i)$), elle est validée et on passe à l'étape de réitération 190. Lorsqu'un tel instant d'arrêt $t_a$ est détecté, la séquence courante $M(t_i)$ est invalidée et l'étape 181 est activée.

Etape 181 : correction de la séquence de modulation précédente. Au cours de cette étape, suite à l'invalidation de la séquence courante $M(t_i)$, la séquence de modulation $M(t_{i-1})$, paramétrée lors de l'instant de modulation $t_{i-1}$ précédent l'instant courant $t_i$, est modifiée, de telle sorte qu'elle s'étende jusqu'à l'instant d'arrêt $t_a$, et qu'elle soit telle que l'intégrale de l'état haut $high(t_{i-1})$ diminué du niveau bas $low(t_{i-1})$, corresponde à l'intégrale du signal de référence $S_{ref}$, diminué du niveau bas $low(t_{i-1})$, entre l'instant $t_{i-1}$ et l'instant d'arrêt $t_a$.

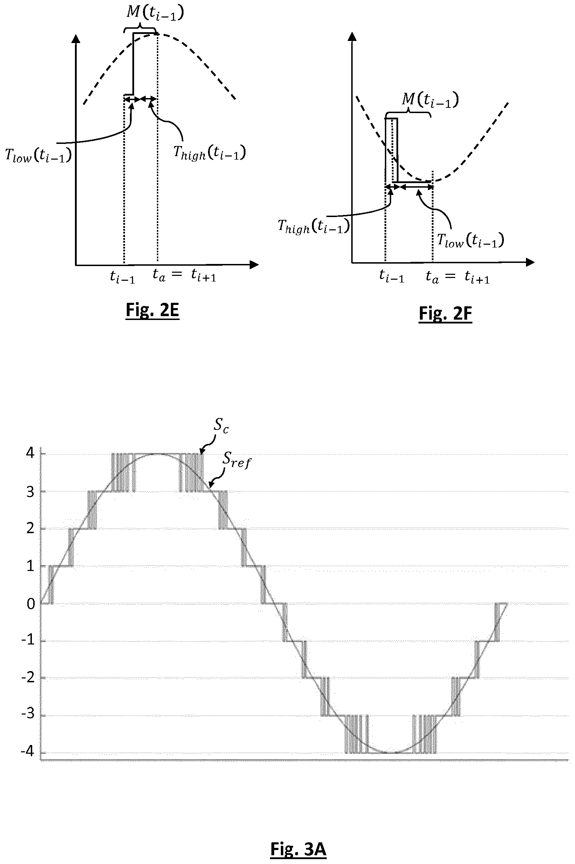

Du fait qu'il n'y ait pas de changement de signe de la dérivée du signal de référence jusqu'à l'instant d'arrêt, la séquence précédente $M(t_{i-1})$ est une première séquence, au sens où elle comporte un état bas suivi d'un état haut. Comme on peut le voir sur la figure 2E, l'état haut est alors prolongé jusqu'à l'instant d'arrêt, et sa durée $T_{high}(t_{i-1})$ est telle que :

$$\int_{t_{i-1}}^{t_a} \left(S_{ref}(k) - low(t_{i-1})\right)dk = (high(t_{i-1}) - low(t_{i-1})) \times T_{high}(t_{i-1}) \ (6)$$

et

$$T(t_{i-1}) = t_a - (t_{i-1}) = T_{low}(t_{i-1}) + T_{high}(t_{i-1}) \ (7)$$

Une telle correction n'est appliquée que pour les itérations suivant la première itération (i = 1), pour laquelle il n'y a pas d'itération précédente. On note d'autre part qu'une telle correction permet de respecter la condition $T_{high}(t_{i-1}) \geq T_{min}$ et $T_{low}(t_{i-1}) \geq T_{min}$.

On décrit à présent les étapes 132, 142, 152, 162, 172 et 182 visant à paramétrer la deuxième séquence. On se réfère à la figure 2B.

Etape 132 : Prise en compte d'une durée minimale. Selon cette étape, on prend en compte une durée minimale $T_{min}(t_i)$, associée à l'instant courant $t_i$ ; la durée de l'état bas est fixée à cette durée minimale : $T_{low}(t_i) = T_{min}(t_i)$. Dans cet exemple, comme vu en lien avec l'étape 131, la durée minimale $T_{min}(t_i)$ est commune à chaque instant courant $t_i$, de telle sorte que pour chacun de ces instants, $T_{min}(t_i) = T_{min}$.

Etape 142 : Détermination d'une durée complémentaire $T_{comp}(t_i)$, telle que définie lors de l'étape 141, et correspondant ici à la durée $T_{high}(t_i)$ de l'état haut. Le niveau haut $high(t_i)$ de l'état haut étant fixé, la durée $T_{high}(t_i)$ de l'état haut est déterminée de telle sorte que l'amplitude de l'état haut, diminuée du niveau bas $low(t_i)$, intégrée selon la durée $T_{high}$ correspond à l'intégrale du signal de référence $S_{ref}$, également diminué du niveau bas $low(t_i)$, durant la durée $T(t_i)$ de la séquence de modulation $M(t_i)$.

Cela peut se traduire par les équations suivantes :

$$\int_{t_i}^{t_i+T} \left(S_{ref}(k) - low(t_i)\right)dk = (high(t_i) - low(t_i)) \times T_{high}(t_i) \ (8)$$

Sachant que $T(t_i) = T_{min} + T_{comp}(t_i) = T_{min} + T_{high}(t_i)$ (9) car $T_{low}(t_i) = T_{min}$

Ces équations forment un système à deux équations, dont les données d'entrée sont $high(t_i)$, $low(t_i)$ et $T_{min}$ et dont les inconnues sont les durées $T(t_i)$ et $T_{high}(t_i)$.

L'équation (8) traduit le fait que lors de chaque séquence, l'intégrale de l'état haut, au-dessus du niveau bas $low(t_i)$, correspond à l'intégrale du signal de référence $S_{ref}$, au-dessus du niveau bas $low(t_i)$. L'intégrale du signal de commande, durant la séquence de modulation, correspond alors à l'intégrale du signal de référence.

Etape 152 : Validation de la séquence. La séquence est validée si la durée complémentaire $T_{comp}(t_i)$ est supérieure ou égale à la durée minimale $T_{min}$: $T_{high}(t_i) \geq T_{min}$. On passe alors à l'étape 172. Dans le cas contraire, la séquence est invalidée et paramétrée selon l'étape 162.

Etape 162 : re-paramétrage de la séquence de modulation. Au cours de cette étape, schématisée sur la figure 2D, la séquence est paramétrée de telle sorte que la durée $T_{high}(t_i)$ de l'état haut est fixée à la durée minimale $T_{min}$. La durée complémentaire $T_{comp}(t_i)$ correspond alors à la durée $T_{low}(t_i)$ de l'état bas ; elle est calculée de telle sorte que l'intégrale de l'état haut, en dessus du niveau bas $low(t_i)$, corresponde à l'intégrale du signal de référence $S_{ref}$, au-dessus du niveau bas, durant la séquence. Cela se traduit par les expressions suivantes :

$$\int_{t_i}^{t_i+T} \left(S_{ref}(k) - low(t_i)\right)dk = (high(t_i) - low(t_i)) \times T_{min} \ (10)$$

et

$$T(t_i) = T_{min} + T_{comp}(t_i) = T_{min} + T_{low}(t_i) \ (11).$$

Ces équations forment un système à deux équations, dont les données d'entrée sont $high(t_i)$, $low(t_i)$ et $T_{min}$ et dont les inconnues sont les durées $T(t_i)$ et $T_{low}(t_i)$.

Etape 172 : Détection d'un instant d'arrêt. La séquence de modulation étant paramétrée, soit suite à l'étape 142, soit suite à l'étape 162, l'étape 172 comporte la détection, au cours de la durée $T(t_i)$ de la séquence, d'un instant

particulier $t_a$, tel que défini dans l'étape 171.

Lorsqu'un tel instant d'arrêt $t_a$ est détecté, la séquence courante $M(t_i)$ est invalidée et l'étape 182 est activée. En l'absence de détection d'un instant d'arrêt, on passe à l'étape 190.

Etape 182 : Correction de la séquence de modulation précédente. Cette étape est représentée sur la figure 2F. La séquence de modulation $M(t_{i-1})$, paramétrée lors de l'instant de modulation $t_{i-1}$ précédent l'instant courant, est modifiée de telle sorte qu'elle s'étende jusqu'à l'instant d'arrêt $t_a$, et qu'elle soit telle que l'intégrale de l'état haut, diminué du niveau bas $low(t_{i-1})$, corresponde à l'intégrale du signal de référence $S_{ref}$, diminué du niveau bas $low(t_{i-1})$, entre l'instant $t_{i-1}$ et l'instant d'arrêt.

Du fait qu'il n'y ait pas de changement de signe de la dérivée du signal de référence jusqu'à l'instant d'arrêt, la séquence précédente $M(t_{i-1})$ est une deuxième séquence, au sens où elle comporte un état haut suivi d'un état bas. L'état bas est alors prolongé jusqu'à l'instant d'arrêt, et la durée est de l'état haut est telle que :

$$\int_{t_{i-1}}^{t_a} \left( S_{ref}(k) - low(t_{i-1}) \right) dk = (high(t_{i-1}) - low(t_{i-1})) \times T_{high}(t_{i-1}) \quad (12)$$

et

$$T(t_{i-1}) = t_a - (t_{i-1}) = T_{high}(t_{i-1}) + T_{low}(t_{i-1}) \quad (13)$$

Une telle correction n'est appliquée que pour les itérations suivant la première itération (i = 1), pour laquelle il n'y a pas d'itération précédente. On note d'autre part qu'une telle correction permet de respecter la condition $T_{low}(t_{i-1}) \geq T_{min}$ et $T_{high}(t_{i-1}) \geq T_{min}$.

Etape 190 : réitération de l'instant courant $t_i$. L'instant courant est incrémenté de façon à correspondre à la fin de la séquence résultant, selon les cas de figure, de l'étape 141, ou de l'étape 161, ou de l'étape 181, ou de l'étape 142, ou de l'étape 162, ou de l'étape 182. Ainsi, en l'absence d'instant d'arrêt détecté au cours de l'itération correspondant à l'instant courant $t_i$,

$$t_{i+1} = t_i + T(t_i)$$

Lorsqu'un instant d'arrêt $t_a$ a été détecté au cours de l'itération correspondant à l'instant courant $t_i$, l'itération suivante débute à l'instant d'arrêt : $t_{i+1} = t_a$

Les étapes 110 à 190 sont réitérées jusqu'à l'atteinte d'un critère d'arrêt, par exemple un nombre d'itérations prédéterminées ou l'atteinte d'un instant maximal. Le signal de commande $S_c$ est progressivement formé par l'ensemble des séquences $M(t_i)$ respectivement formées à chaque itération.

Le procédé décrit ci-avant présente les avantages suivants :

- une adaptation au sens de variation du signal de référence, de telle sorte que lorsque le signal de référence $S_{ref}$ est croissant, les séquences sont différentes de celles établies lorsque le signal de référence est décroissant. La morphologie de chaque séquence est adaptée au sens de variation du signal de référence : niveau bas puis niveau haut lorsque le signal de référence est croissant ; niveau haut puis niveau bas lorsque le signal de référence est décroissant. Cela minimise la distance moyenne, durant chaque séquence, entre le signal de commande $S_c$, et le signal de référence $S_{ref}$. Le signal de commande est alors plus proche du signal de référence. A la fin de la séquence, le signal de commande peut notamment atteindre :

  un niveau haut, ce qui le rend plus proche du niveau bas de la séquence suivante, lorsque le niveau bas $low(t_{i+1})$ de la séquence suivante correspond au niveau haut $high(t_i)$ de la séquence courante, ce qui est représenté sur la figure 2C,
  ou un niveau bas, ce qui le rend plus proche du niveau haut de la séquence suivante, lorsque le niveau haut $high(t_{i+1})$ de la séquence suivante correspond au niveau bas $low(t_i)$ de la séquence courante.

Cela réduit l'erreur moyenne du signal de commande $S_c$ par rapport au signal de référence $S_{ref}$.

- une prise en compte d'une durée minimale $T_{min}$, affectant soit l'état bas, soit l'état haut, de manière à limiter le nombre de commutations entre les deux états. Cela permet de limiter les pertes de commutation, résultant de commutations trop rapides entre différents états. La durée minimale permet de garantir un intervalle temporel minimal entre deux commutations. La durée de chaque séquence est alors déterminée en fonction d'une durée dite com-

plémentaire $T_{comp}(t_i)$, s'ajoutant à la durée minimale. La durée complémentaire est déterminée en prenant en compte l'intégrale du signal de référence $S_{ref}$ durant chaque séquence, de manière à ce que l'énergie du signal de commande $S_c$, à chaque séquence, se rapproche le plus possible de l'énergie du signal de référence $S_{ref}$. On notera que dans les procédés de l'art antérieur, le rapport cyclique est déterminé en fonction d'une valeur du signal de référence durant des instants donnés, mais pas en fonction d'une intégrale de la valeur du signal de référence durant chaque séquence de modulation.

- une prise en compte d'instants d'arrêt $t_a$, représentant une réalité physique (fin de période, signal de référence nul, changement de signe de la dérivée), et une synchronisation de chaque séquence en fonction de ces instants d'arrêt. Par exemple, si l'on considère un signal sinusoïdal s'étendant de part et d'autre d'une valeur nulle, un instant d'arrêt correspond à chaque quart de période. Le signal de commande généré respecte alors l'aspect périodique du signal de référence et assure une certaine symétrie de part et d'autre des instants d'arrêt $t_a$.

La figure 1B schématise un dispositif permettant la mise en œuvre de l'invention. Il est constitué d'un générateur 10 du signal de référence $S_{ref}$, ainsi que d'un processeur 20, configuré pour mettre en œuvre les étapes telles que précédemment décrites pour établir successivement les différentes séquences constituant le signal de commande $S_c$. Le signal de commande ainsi généré est adressé à un générateur du signal de commande 30, ce dernier générant le signal de commande à destination d'un système à contrôler 40, par exemple un moteur.

La figure 3A représente un signal de référence $S_{ref}$ sinusoïdal, ainsi qu'un signal de commande $S_c$ comportant des séquences de modulation obtenues en mettant en œuvre le mode de réalisation précédemment décrit, en considérant une discrétisation selon 9 niveaux. On observe que le nombre de commutations est limité. On observe également une symétrie du signal de commande sur une période. Ainsi, lorsque le signal à moduler est périodique, ce qui correspond à un cas d'application usuel, les séquences de modulation définies sur une période du signal de référence $S_{ref}$ peuvent être mémorisées et reproduites pour chaque période, voire sur une demi-période ou un quart de période du signal de référence. Cela permet d'économiser les ressources en calcul et/ou en mémoire du processeur. Le procédé est particulièrement adapté au pilotage de systèmes embarqués, par exemple des véhicules, dans lesquels les ressources du processeur doivent être optimisées pour minimiser la consommation en énergie.

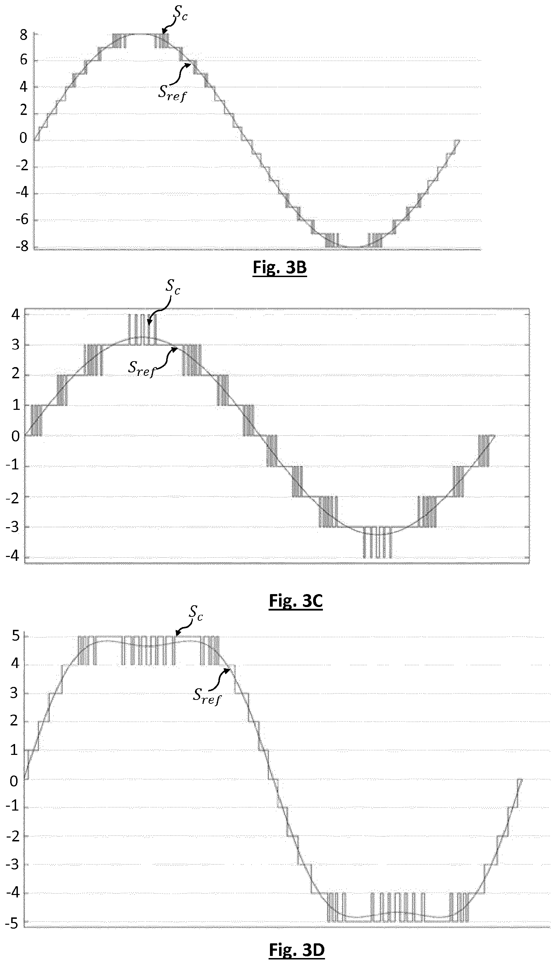

La figure 3B représente un exemple de modulation d'un signal sinusoïdal en considérant 17 niveaux. Dans les exemples de la figure 3A et 3B, les valeurs crêtes du signal de référence correspondent respectivement au niveau minimal (- 4 sur la figure 3A, - 8 sur la figure 3B) et au niveau maximal (+ 4 sur la figure 3A, + 8 sur la figure 3B). Sur la figure 3C, on a représenté une modulation effectuée sur une configuration dans laquelle les valeurs crêtes du signal de référence $S_{ref}$ ne coïncident pas avec des valeurs de niveaux. On observe à nouveau la symétrie du signal de commande.

La figure 3D montre un exemple de modulation d'un signal comportant une composante sinusoïdale principale complété d'une composante harmonique de rang 3. La composante harmonique de rang 3 a une fréquence trois fois plus élevée que la fréquence de la composante principale, et a une amplitude moindre que cette dernière. Cela illustre le fait que l'invention s'applique à des signaux périodiques complexes. Cela rend l'invention applicable au pilotage de machines électriques par des signaux sinusoïdaux avec injection d'harmoniques. Par exemple, une telle configuration permet de piloter une des phases d'un moteur triphasé. La périodicité du signal de commande permet de ne mémoriser que les informations relatives aux niveaux et aux durées écoulées depuis le début d'une période. On peut par exemple constituer un vecteur comportant les niveaux et un vecteur comportant les durées s'écoulant depuis le début d'une période. Ces vecteurs peuvent être mémorisés, ce qui permet la génération du signal de commande tout en optimisant l'espace mémoire et limitant les besoins en calcul, par une simple application répétitive de séquences mémorisées.

Le couplage avec des capteurs à effet Hall, disposés dans le moteur, permet d'utiliser l'information résultant des capteurs à effet Hall à des fins de synchronisation. En effet, un capteur à effet Hall peut générer un signal relatif à une orientation, le signal généré présentant deux transitions à chaque période. Chaque transition permet de former une information angulaire quant à la position du rotor par rapport au stator, permettant la synchronisation du signal de commande.

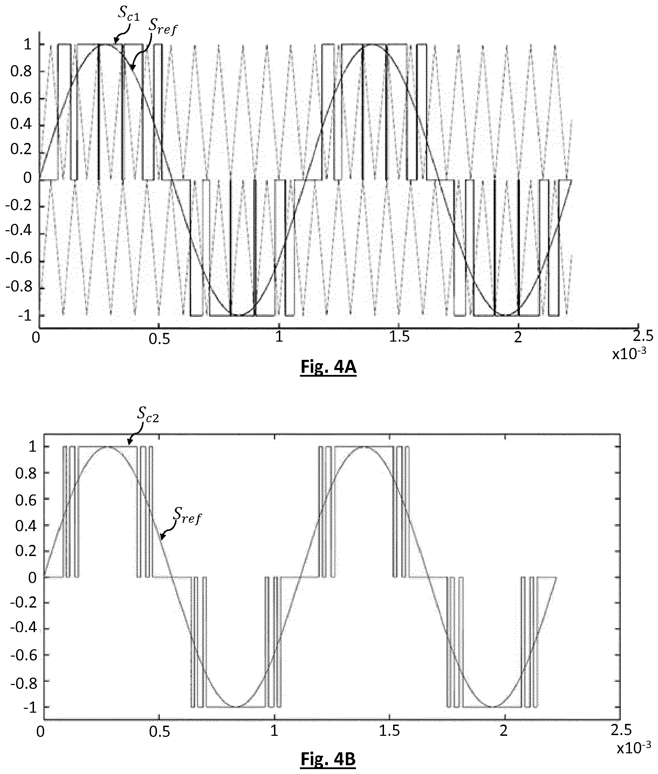

Les inventeurs ont réalisé des simulations permettant de mettre en évidence certains avantages de l'invention. Ces simulations sont présentées ci-après, en lien avec les figures 4A à 4D.

La figure 4A montre un signal de référence $S_{ref}$ sinusoïdal, ainsi qu'un premier signal de commande $S_{c1}$ établi selon un procédé de modulation de l'art antérieur. Selon ce procédé, une porteuse triangulaire est appliquée entre deux niveaux successifs, et les niveaux haut et bas du signal de commande sont déterminés selon des intersections entre la porteuse triangulaire et le signal de commande.

La figure 4B représente le signal de référence sinusoïdal, ainsi qu'un deuxième signal de commande $S_{c2}$ obtenu en mettant en œuvre le procédé précédemment décrit. Le signal $S_{c2}$ comporte le même nombre de commutations du signal $S_{c1}$

En comparant les figures 4A et 4B, on observe que le deuxième signal de commande $S_{c2}$ respecte bien une condition selon laquelle la durée de chaque état, bas ou haut, est supérieure ou égale à une durée minimale, ce qui n'est pas le cas du premier signal de commande S$_{c1}$.

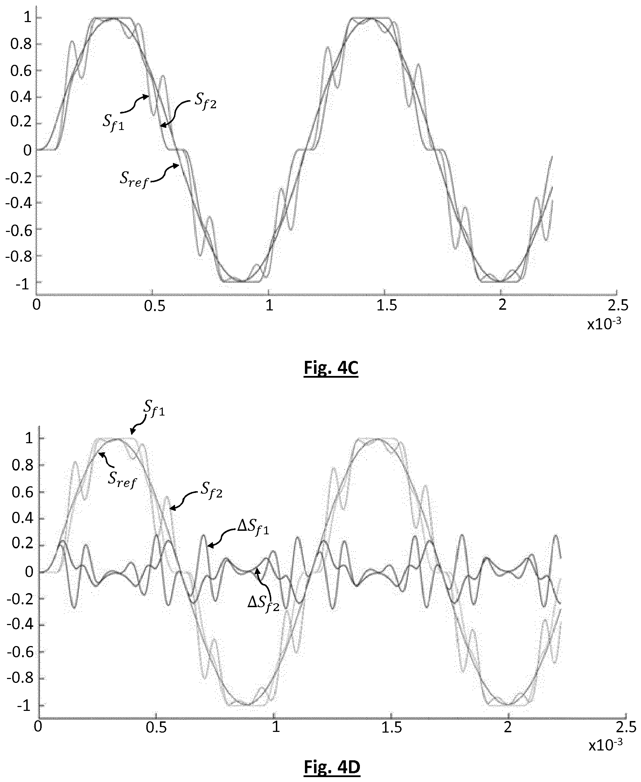

Un filtrage passe-bas a été appliqué aux signaux de commandes S$_{c1}$ et S$_{c2}$ respectivement représentés sur les figures 4A et 4B. On a ainsi obtenu un premier signal filtré S$_{f1}$ à partir du signal de commande représenté sur la figure 4A, obtenu selon l'art antérieur, et un deuxième signal filtré S$_{f2}$, à partir du signal de commande représenté sur la figure 4B, obtenu selon l'invention. La figure 4C représente le premier signal filtré, le deuxième signal filtré ainsi que le signal de référence. Il est rappelé que la modulation du signal de référence S$_{ref}$ est d'autant plus performante que le signal de commande S$_{c}$, après filtrage, est proche du signal de référence.

La figure 4D montre un premier signal différentiel $\Delta S_{f1}$ ainsi qu'un deuxième signal différentiel $\Delta S_{f2}$ obtenus respectivement par une soustraction entre le signal de référence et le premier signal filtré, et entre le signal de référence et le deuxième signal filtré : $\Delta S_{f1} = S_{ref} - S_{f1}$ et $\Delta S_{f2} = S_{ref} - S_{f2}$. Le signal différentiel permet d'observer visuellement les performances de chaque modulation. On constate que l'amplitude du deuxième signal différentiel est moindre que l'amplitude du premier signal différentiel, ce qui atteste de la performance supérieure de la modulation effectuée par l'invention. Les inventeurs ont calculé que dans cet exemple, la mise en œuvre de l'invention conduit à une réduction de l'erreur quadratique moyenne $\Delta(MSE)$ de 27.37 %, cette erreur étant calculée selon l'expression

$$\Delta(MSE) = \left(1 - \frac{MSE(S_{c2})}{MSE(S_{c1})}\right) \times 100$$

Avec :

$$MSE(S_{c1}) = \frac{1}{n}\sum_{i=1}^{n}\left(S_{ref_i} - S_{c1_i}\right)^2 \text{ et } MSE(S_{c2}) = \frac{1}{n}\sum_{i=1}^{n}\left(S_{ref_i} - S_{c2_i}\right)^2$$

n étant un entier désignant chaque échantillon pris en compte pour le calcul de la moyenne.

L'invention pourra s'appliquer à l'alimentation électrique de systèmes de puissance, par exemple des moteurs, ou encore à l'échange d'énergie avec le réseau électrique. Elle trouve notamment son application sur des véhicules électriques, par exemple des voitures ou des bicyclettes ou dans des systèmes de stockage stationnaires.

**Revendications**

1. Procédé de génération d'un signal de commande ($S_c$) par modulation d'impulsions en fonction d'un signal de référence ($S_{ref}$), le procédé comportant une formation de séquences de modulation successives, chaque séquence comportant une transition entre un état bas et un état haut ou réciproquement, le procédé comportant les étapes itératives suivantes, chaque itération étant associée à un instant, dit instant courant :

   a) calcul d'une dérivée temporelle ($S'_{ref}(t_i)$) du signal de référence, la dérivée étant associée à une séquence de modulation, dite séquence courante, correspondant à l'instant courant ($t_i$);
   b) en fonction de la dérivée temporelle du signal de référence [$S'_{ref}(t_i)$) calculée lors de l'étape a), définition de la séquence courante ($M(t_i)$), de telle sorte que :

   - lorsque la dérivée est positive, la séquence courante ($M(t_i)$) comporte un état haut précédé d'un état bas, l'état haut s'étendant jusqu'à la fin de la séquence courante;
   - lorsque la dérivée est négative, la séquence courante ($M(t_i)$) comporte un état haut suivi d'un état bas, l'état bas s'étendant jusqu'à la fin de la séquence courante;

   l'état bas et l'état haut s'étendant respectivement selon une durée d'état bas ($T_{low}(t_i)$) et une durée d'état haut ($T_{high}(t_i)$), la séquence courante ($M(t_i)$), s'étendant, à partir de l'instant courant ($t_i$), selon une durée de séquence ($T(t_i)$) ;
   c) prise en compte d'un niveau haut ($high(t_i)$), correspondant à l'état haut, et d'un niveau bas ($low(t_i)$), correspondant à l'état bas, le niveau haut étant strictement supérieur au niveau bas ;
   d) en fonction de l'amplitude du signal de référence ($S_{ref}$) et des niveaux haut et bas pris en compte lors de l'étape c), détermination de la durée ($T_{high}(t_i)$) de l'état haut ou de la durée ($T_{low}(t_i)$) de l'état bas de la séquence courante définie lors de l'étape b)
   e) réitération des étapes a) à e), en incrémentant l'instant courant d'une durée égale à la durée de la séquence résultant de l'étape d), ou arrêt des itérations ;

le procédé comportant également une génération du signal de commande ($S_c$), en fonction des séquences de modulation définies lors des étapes d) des différentes itérations.

2. Procédé selon la revendication 1, dans lequel l'étape d) comporte une prise en compte d'une durée minimale ($T_{min}$), ainsi que les sous-étapes suivantes :

di) en fonction de la séquence définie lors de l'étape b), et de l'amplitude du signal de référence durant la durée de séquence, calcul d'une durée complémentaire, la durée complémentaire correspondant :

  - à la durée ($T_{low}(t_i)$) de l'état bas lorsque la dérivée du signal de référence est positive, la durée ($T_{high}(t_i)$) de l'état haut étant alors fixée à la durée minimale ($T_{min}$);
  - à la durée ($T_{high}(t_i)$) de l'état haut lorsque la dérivée du signal de référence est négative, la durée ($T_{low}(t_i)$) de l'état bas étant alors fixée à la durée minimale ($T_{min}$);

dii) comparaison de la durée complémentaire ($T_{comp}(t_i)$) et de la durée minimale ($T_{min}(t_i)$);
diii) lorsque la durée complémentaire ($T_{comp}(t_i)$) est inférieure à la durée minimale ($T_{min}$), invalidation de la durée complémentaire résultant de la sous-étape di), et détermination d'une durée complémentaire correspondant à :

  - la durée ($T_{high}(t_i)$) de l'état haut, lorsque la dérivée du signal de référence est positive, la durée de l'état bas étant alors fixée à la durée minimale ($T_{min}$);
  - la durée ($T_{low}(t_i)$) de l'état bas, lorsque a dérivée du signal de référence est négative, la durée de l'état haut étant alors fixée à la durée minimale ($T_{min}$).

3. Procédé selon l'une quelconque des revendications précédentes, dans lequel lors de l'étape d), la durée complémentaire est calculée en fonction de l'intégrale du signal de référence durant la durée de la séquence courante ($T(t_i)$) et du niveau haut (($high(t_i)$) pris en compte lors de l'étape c).

4. Procédé selon la revendication 3, dans lequel lors de l'étape d), la durée complémentaire est calculée de telle sorte que l'intégrale du signal de référence, diminué du niveau bas ($low((t_i)$), durant la durée de séquence ($T(t_i)$), est égale, à une tolérance prédéterminée près, au produit du niveau haut (($high(t_i)$), diminué du niveau bas ($low((t_i)$), par la durée ($T_{high}(t_i)$) de l'état haut.

5. Procédé selon l'une quelconque des revendications précédentes, comportant les sous-étapes suivantes :

div) détermination de la présence d'un instant, dit d'arrêt ($t_a$), correspondant à un instant caractéristique du signal de référence ou de sa dérivée, durant la séquence courante ($M(t_i)$);
dv) lorsqu'un instant d'arrêt est détecté, annulation de la séquence courante ($M(t_i)$) et ajustement de la séquence précédente ($M(t_{i-1})$), définie lors de l'itération précédente, de façon que la séquence précédente s'étende entre l'instant précédent ($t_{i-1}$) et l'instant d'arrêt ($t_a$).

6. Procédé selon la revendication 5, dans lequel la séquence précédente est ajustée de façon que:

  - lorsque, à l'instant précédent, la dérivée du signal de référence est positive, l'état haut de la séquence précédente s'étend jusqu'à l'instant d'arrêt ($t_a$) ;
  - lorsque, à l'instant précédent, la dérivée du signal de référence est négative, l'état bas de la séquence précédente s'étend jusqu'à l'instant d'arrêt ($t_a$).

7. Procédé selon l'une quelconque des revendications 5 à 6, dans lequel l'instant d'arrêt ($t_a$) correspond :

  - à un instant auquel le signal de référence change de signe ;
  - ou à un instant auquel la dérivée du signal de référence change de signe ;
  - ou le signal de référence étant périodique, à un instant correspondant à la fin d'une période du signal de référence ;
  - ou à un instant auquel le signal de référence atteint l'état haut ($high(t_i)$) ou l'état bas ($low(t_i)$).

8. Procédé selon l'une quelconque des revendications précédentes, dans lequel lors de l'étape b), la séquence définie comporte un seul état haut et un seul état bas.

9.  Procédé selon l'une quelconque des revendications précédentes, dans lequel lors de l'étape c), la détermination du niveau haut et du niveau bas est effectuée en fonction de valeurs prédéterminées, et en fonction du signal de référence durant la durée de l'impulsion.

10. Dispositif de génération d'un signal de commande ($S_c$), en fonction d'un signal de référence ($S_{ref}$), le dispositif comportant un processeur (20) apte à mettre les étapes a) à e) d'un procédé selon l'une quelconque des revendications précédentes, en fonction du signal de référence.

**Patentansprüche**

1.  Verfahren zur Erzeugung eines Steuersignals ($S_c$) durch Impulsmodulation abhängig von einem Bezugssignal ($S_{ref}$), wobei das Verfahren eine Bildung von aufeinanderfolgenden Modulationssequenzen aufweist, wobei jede Sequenz einen Übergang zwischen einem niedrigen Zustand und einem hohen Zustand oder umgekehrt aufweist, wobei das Verfahren die folgenden iterativen Schritte aufweist, wobei jede Iteration einem aktueller Zeitpunkt genannten Zeitpunkt zugeordnet ist:

    a) Berechnung einer zeitlichen Ableitung ($S'_{ref}(t_i)$) des Bezugssignals, wobei die Ableitung einer aktuelle Sequenz genannten Modulationssequenz zugeordnet ist, die dem aktuellen Zeitpunkt ($t_i$) entspricht;
    b) abhängig von der im Schritt a) berechneten zeitlichen Ableitung des Bezugssignals ($S'_{ref}(t_i)$), Definition der aktuellen Sequenz ($M(t_i)$) derart, dass gilt:

    • wenn die Ableitung positiv ist, weist die aktuelle Sequenz ($M(t_i)$) einen hohen Zustand auf, dem ein niedriger Zustand vorausgeht, wobei der hohe Zustand sich bis zum Ende der aktuellen Sequenz erstreckt;
    • wenn die Ableitung negativ ist, weist die aktuelle Sequenz ($M(t_i)$) einen hohen Zustand gefolgt von einem niedrigen Zustand auf, wobei der niedrige Zustand sich bis zum Ende der aktuellen Sequenz erstreckt;

    wobei der niedrige Zustand und der hohe Zustand sich gemäß einer Dauer niedrigen Zustands ($T_{low}(t_i)$) bzw. einer Dauer hohen Zustands ($T_{high}(t_i)$) erstrecken, wobei die aktuelle Sequenz ($M(t_i)$) sich ausgehend vom aktuellen Zeitpunkt ($t_i$) gemäß einer Sequenzdauer ($T(t_i)$) erstreckt;
    c) Berücksichtigung eines hohen Pegels ($high(t_i)$) entsprechend dem hohen Zustand und eines niedrigen Pegels ($low(t_i)$) entsprechend dem niedrigen Zustand, wobei der hohe Pegel strikt höher als der niedrige Pegel ist;
    d) abhängig von der Amplitude des Bezugssignals ($S_{ref}$) und den im Schritt c) berücksichtigten hohen und niedrigen Pegeln, Bestimmung der Dauer ($T_{high}(t_i)$) des hohen Zustands oder der Dauer ($T_{low}(t_i)$) des niedrigen Zustands der im Schritt b) definierten aktuellen Sequenz;
    e) Wiederholung der Schritte a) bis e), indem der aktuelle Zeitpunkt um eine Dauer gleich der Dauer der aus dem Schritt d) resultierenden Sequenz inkrementiert wird, oder Ende der Iterationen;
    wobei das Verfahren ebenfalls eine Erzeugung des Steuersignals ($S_c$) abhängig von den in den Schritten d) der verschiedenen Iterationen definierten Modulationssequenzen aufweist.

2.  Verfahren nach Anspruch 1, wobei der Schritt d) eine Berücksichtigung einer minimalen Dauer ($T_{min}$) sowie die folgenden Teilschritte aufweist:

    di) abhängig von der im Schritt b) definierten Sequenz und der Amplitude des Bezugssignals während der Sequenzdauer, Berechnung einer komplementären Dauer, wobei die komplementäre Dauer entspricht:

    • der Dauer ($T_{low}(t_i)$) des niedrigen Zustands, wenn die Ableitung des Bezugssignals positiv ist, wobei die Dauer ($T_{high}(t_i)$) des hohen Zustands dann auf die minimale Dauer ($T_{min}$) festgelegt wird;
    • der Dauer ($T_{high}(t_i)$) des hohen Zustands, wenn die Ableitung des Bezugssignals negativ ist, wobei die Dauer ($T_{low}(t_i)$) des niedrigen Zustands dann auf die minimale Dauer ($T_{min}$) festgelegt wird;

    dii) Vergleich der komplementären Dauer ($T_{comp}(t_i)$) und der minimalen Dauer ($T_{min}(t_i)$);
    diii) wenn die komplementäre Dauer ($T_{comp}(t_i)$) geringer als die minimale Dauer ($T_{min}$) ist, Ungültigmachung der aus dem Teilschritt di) resultierenden komplementären Dauer und Bestimmung einer komplementären Dauer entsprechend:

    • der Dauer ($T_{high}(t_i)$) des hohen Zustands, wenn die Ableitung des Bezugssignals positiv ist, wobei die Dauer des niedrigen Zustands dann auf die minimale Dauer ($T_{min}$) festgelegt wird;

• der Dauer (Tiow(ti)) des niedrigen Zustands, wenn die Ableitung des Bezugssignals negativ ist, wobei die Dauer des hohen Zustands dann auf die minimale Dauer ($T_{min}$) festgelegt wird.

3. Verfahren nach einem der vorhergehenden Ansprüche, wobei im Schritt d) die komplementäre Dauer abhängig vom Integral des Bezugssignals während der Dauer der aktuellen Sequenz (T(ti)) und dem im Schritt c) berücksichtigten hohen Pegel ((high($t_i$)) berechnet wird.

4. Verfahren nach Anspruch 3, wobei im Schritt d) die komplementäre Dauer so berechnet wird, dass das Integral des Bezugssignals, verringert um den niedrigen Pegel (low(($t_i$)), während der Sequenzdauer (T($t_i$)), bis auf eine vorbestimmte Toleranz gleich dem Produkt aus dem hohen Pegel ((high($t_i$)), verringert um den niedrigen Pegel (low(($t_i$)), und der Dauer ($T_{high}(t_i)$) des hohen Zustands ist.

5. Verfahren nach einem der vorhergehenden Ansprüche, das die folgenden Teilschritte aufweist:

   div) Bestimmung des Vorhandenseins eines so genannten Stoppzeitpunkts ($t_a$) entsprechend einem charakteristischen Zeitpunkt des Bezugssignals oder seiner Ableitung während der aktuellen Sequenz (M($t_i$));
   dv) wenn ein Stoppzeitpunkt erfasst wird, Annullierung der aktuellen Sequenz (M(ti)) und Anpassung der in der vorhergehenden Iteration definierten vorhergehenden Sequenz (M($t_{i-1}$)), damit die vorhergehende Sequenz sich zwischen dem vorhergehenden Zeitpunkt ($t_{i-1}$) und dem Stoppzeitpunkt ($t_a$) erstreckt.

6. Verfahren nach Anspruch 5, wobei die vorhergehende Sequenz so angepasst wird, dass:

   • wenn im vorhergehenden Zeitpunkt die Ableitung des Bezugssignals positiv ist, der hohe Zustand der vorhergehenden Sequenz sich bis zum Stoppzeitpunkt ($t_a$) erstreckt;
   • wenn im vorhergehenden Zeitpunkt die Ableitung des Bezugssignals negativ ist, der niedrige Zustand der vorhergehenden Sequenz sich bis zum Stoppzeitpunkt ($t_a$) erstreckt.

7. Verfahren nach einem der Ansprüche 5 bis 6, wobei der Stoppzeitpunkt ($t_a$) entspricht:

   • einem Zeitpunkt, in dem das Bezugssignal sein Vorzeichen ändert;
   • oder einem Zeitpunkt, in dem die Ableitung des Bezugssignals ihr Vorzeichen ändert;
   • oder, wenn das Bezugssignal periodisch ist, einem Zeitpunkt, der dem Ende einer Periode des Bezugssignals entspricht;
   • oder einem Zeitpunkt, in dem das Bezugssignal den hohen Zustand (high(ti)) oder den niedrigen Zustand (low($t_i$)) erreicht.

8. Verfahren nach einem der vorhergehenden Ansprüche, wobei im Schritt b) die definierte Sequenz einen einzigen hohen Zustand und einen einzigen niedrigen Zustand aufweist.

9. Verfahren nach einem der vorhergehenden Ansprüche, wobei im Schritt c) die Bestimmung des hohen Pegels und des niedrigen Pegels abhängig von vorbestimmten Werten und abhängig vom Bezugssignal während der Impulsdauer ausgeführt wird.

10. Vorrichtung zur Erzeugung eines Steuersignals ($S_c$) abhängig von einem Bezugssignal ($S_{ref}$), wobei die Vorrichtung einen Prozessor (20) aufweist, der die Schritte a) bis e) eines Verfahrens nach einem der vorhergehenden Ansprüche abhängig vom Bezugssignal durchführen kann.

**Claims**

1. Method for generating a control signal ($S_c$) by pulse modulation according to a reference signal ($S_{ref}$), the method comprising forming successive modulation sequences, each sequence comprising a transition between a low state and a high state or vice versa, the method comprising the following iterative steps, each iteration being associated with a current instant:

   a) calculating a time derivative ($S'_{ref}(t_i)$) of the reference signal, the time derivative being associated with a current modulation sequence corresponding to the current instant ($t_i$);
   b) according to the time derivative of the reference signal ($S'_{ref}(t_i)$) calculated in a), defining the current sequence

$(M(t_i))$, such that:

- when the derivative is positive, the current sequence $(M(t_i))$ comprises a high state preceded by a low state, the high state extending up to the end of the current sequence;
- when the derivative is negative, the current sequence $(M(t_i))$ comprises a high state followed by a low state, the low state extending up to the end of the current sequence;

the low state and the high state extending over a low state duration $(T_{low}(t_i))$ and a high state duration $(T_{high}(t_i))$ respectively, the current sequence $(M(t_i))$ extending from the current instant $(t_i)$, over a sequence duration $(T(t_i)$;
c) taking into account a high level $(high(t_i))$, corresponding to the high state, and a low level $(low(t_i))$, corresponding to the low state, the high level being strictly greater than the low level;
d) according to the amplitude of the reference signal $(S_{ref})$ and the high and low levels taken into account in c), determining the duration $(T_{high}(t_i))$ of the high state or the duration $(T_{low}(t_i))$ of the low state of the current sequence defined in step b);
e) reiterating steps a) to e), by incrementing the current instant by a duration equal to the duration of the sequence resulting from d), or stopping the iterations;
the method also comprising:

generating the control signal $(S_c)$, according to the modulation sequences defined in steps d) of the different iterations.

2. Method according to Claim 1, wherein d) comprises taking into account a minimum duration $(T_{min})$, and:

di) according to the sequence defined in b), and the amplitude of the reference signal during the sequence duration, calculating an additional duration, the additional duration corresponding to:

- the duration $(T_{low}(t_i))$ of the low state when the derivative of the reference signal is positive, the duration $(T_{high}(t_i)))$ of the high state then being set to the minimum duration $(T_{min})$;
- the duration $(T_{high}(t_i))$ of the high state when the derivative of the reference signal is negative, the duration $(T_{low}(t_i))$ of the low state then being set to the minimum duration $(T_{min})$;

dii) comparing the additional duration $(T_{comp}(t_i))$ and the minimum duration $((T_{min}(t_i))$;
diii) when the additional duration $(T_{comp}(t_i)$ is less than the minimum duration $(T_{min})$, invalidating the additional duration resulting from di), and determining an additional duration corresponding to:

- the duration of the high state $(T_{high}(t_i))$, when the derivative of the reference signal is positive, the duration of the low state then being set to the minimum duration $(T_{min})$;
- or the duration of the low state $(T_{low}(t_i))$, when the derivative of the reference signal is negative, the duration of the high state then being set to the minimum duration $(T_{min})$.

3. Method according any one of the preceding claims, wherein in d), the additional duration is calculated according to the integral of the reference signal during the duration of the current sequence $(T(t_i))$ and the high level $((high(t_i))$ taken into account in c).

4. Method according to Claim 3, wherein in d), the additional period is calculated so that the integral of the reference signal, reduced by the low level $(low((t_i))$, during the sequence duration $(T(t_i))$, is equal, to within a predetermined tolerance, to the product of the high level $((high(t_i))$, reduced by the low level $(low((t_i))$, by the duration of the high state $(T_{high}(t_i)$.

5. Method according to any one of the preceding claims, comprising:

div) determining the presence of a stopping instant $(t_a)$, corresponding to an instant characteristic of the reference signal or of its time derivative, during the current sequence $(M(t_i))$;
dv) when a stopping instant is detected, cancelling the current sequence $(M(t_i))$, and adjusting the preceding sequence $(M(t_{i-1}))$, defined in the preceding iteration, so that the preceding sequence extends between the preceding instant $(t_{i-1})$ and the stopping instant $(t_a)$.

6. Method according to Claim 5, wherein the preceding sequence is adjusted so that:

- when, at the preceding instant, the time derivative of the reference signal is positive, the high state of the preceding sequence extends up to the stopping instant ($t_a$);
- when at the preceding instant, the time derivative of the reference signal is negative, the low state of the preceding sequence extends up to the stopping instant ($t_a$).

7. Method according to any one of Claim 5 or Claim 6, wherein the stopping instant ($t_a$) corresponds:

- to an instant whereat the reference signal changes sign;
- or to an instant whereat the derivative of the reference signal changes sign;
- or the reference signal being periodic, to an instant corresponding to the end of a period of the reference signal;
- or to an instant whereat the reference signal reaches the high state ($high(t_i)$) or the low state ($low(t_i)$).

8. Method according to any one the preceding claims, wherein in b), the defined sequence comprises only one high state and only one low state.

9. Method according to any one the preceding claims, wherein in c), determining the high level and the low level is performed according to predetermined values, and according to the reference signal during the duration of the pulse.

10. Device for generating a control signal ($S_c$), according to a reference signal ($S_{ref}$), the device comprising a processor capable of implementing steps a) to e) of a method according to any one of the preceding claims, according to the reference signal.

**Fig. 1A**

**Fig. 1B**

**Fig. 2A**

**Fig. 2B**

**Fig. 2C**

**Fig. 2D**

**Fig. 2E**

**Fig. 2F**

**Fig. 3A**

**Fig. 3B**

**Fig. 3C**

**Fig. 3D**

**Fig. 4A**

**Fig. 4B**

EP 3 506 486 B1

**Fig. 4C**

**Fig. 4D**

21

## RÉFÉRENCES CITÉES DANS LA DESCRIPTION

**Documents brevets cités dans la description**

- EP 0745951 A

- EP 0336019 A